# EUROPÄISCHE PATENTSCHRIFT

(11) **EP 1 191 591 B1**
(45) Veröffentlichungstag und Bekanntmachung des Hinweises auf die Patenterteilung: **06.10.2010**
(21) Anmeldenummer: 01120582.0
(22) Anmeldetag: 29.08.2001
(51) Int. Cl.: H01L 23/544

(54) **Verfahren und Markierung zum Kennzeichnen integrierter Schaltkreise**
Method and mark for labelling integrated circuit
Procédé et marque pour l'étiquetage de circuits intégrés

(30) Priorität: 08.09.2000 DE 10044502
(43) Veröffentlichungstag der Anmeldung: 27.03.2002
(73) Patentinhaber: Infineon Technologies AG, 85579 Neubiberg (DE)
(72) Erfinder: Biedermann, Ernst, 93053 Regensburg (DE)
(74) Vertreter: Kindermann, Peter

(56) Entgegenhaltungen:
- US-A- 5 654 204
- US-A- 5 923 996
- PATENT ABSTRACTS OF JAPAN vol. 007, no. 204 (E-197), 9. September 1983 (1983-09-09) & JP 58 103150 A (MATSUSHITA DENKI SANGYO KK), 20. Juni 1983 (1983-06-20)

## Beschreibung

Die Erfindung betrifft ein Verfahren zum Kennzeichnen von integrierten Schaltkreisen auf Wafern mit einer Markierungsowie ein Verfahren zum Dünnschleifen von Wafern und insbesondere die Verwendung von Tinte und Tintenstrahldruckverfahren zum Kennzeichnen von funktionsfähigen integrierten Schaltkreisen.

Integrierte Halbleiter werden bereits den ersten Prüfschritten unterzogen, wenn sie noch in ihrem Verbund mit einer Vielzahl integrierter Halbleiter auf einem Wafer vorliegen. Die Prüfschritte dienen beispielsweise der Feststellung der Funktionalität der integrierten Schaltkreise oder der Bestimmung ihrer Leistungscharakteristik, wie beispielsweise unterschiedlicher, möglicher Geschwindigkeiten.

Nach den Prüfschritten werden die geprüften integrierten Schaltkreise durch Aufbringen einer Kennzeichnung auf ihrer Oberfläche markiert. Diese Kennzeichnung kann ein einfacher Punkt oder eine komplexe Angabe, wie ein Barcode oder eine Ziffernbeschriftung sein.

Wafer werden nach der Herstellung der auf ihnen angeordneten integrierten Schaltkreise dünn geschliffen. Ein allgemeines Ziel ist dabei, die Wafer erst am Ende des Prozessablaufs im Prüffeld und insbesondere auch nach Anbringen der Kennzeichnungen dünn zu schleifen. Allerdings verlieren durch das Dünnschleifen die Wafer mechanische Stabilität und sind auf undefinierte Weise gebogen. Die Handhabung solcher Scheiben ist mit erhöhter Bruchgefahr verbunden. Bisher verwendete Markierungstechniken zur Anbringung der Kennzeichnung sind so dick, dass auf Grund auftretender Hebelkräfte an den Kennzeichnungen ein mit der markierten Seite auf einem Chuck aufliegender Wafer beim Dünnschleifen brechen kann. Es ist daher nicht möglich gewesen, heutige dünne Wafer erst nach Anbringen der Kennzeichnung dünn zu schleifen.

Die Druckschrift JP-A-58 103 150 offenbart ein Verfahren zur Herstellung von Halbleitersubstraten, wobei ein Durchsatz bei einem Maskenpositionierungsprozess verbessert ist. Hierbei werden Markierungen mittels Tintenstrahl auf einem Baustein aufgebracht, wenn eine Erst-Inspektion (optisch) ergibt, dass der Baustein fehlerhafte Strukturen aufweist. Erst bei einer nachfolgenden Zweit-Inspektion (elektrisch), die nur für unmarkierte Bausteine durchgeführt wird, werden die elektrischen Eigenschaften getestet. Falls der Baustein elektrisch defekt ist, wird wiederum eine Markierung aufgebracht. Somit ist nur eine Markierung von defekten Bausteinen offenbart.

Aus der Druckschrift US-A-5 654 204 ist ein weiteres herkömmliches Verfahren zum Kennzeichnen von defekten Bausteinen auf einem Wafer bekannt, wobei die "schlechten" Bausteine mit einer Tintenmarkierung gekennzeichnet werden.

Demgegenüber liegt der Erfindung die Aufgabe zugrunde, ein Verfahren zur Kennzeichnung von integrierten Schaltkreisen auf einem Wafer bereitzustellen, das eine effektive Weiterverarbeitung von funktionsfähigen Schaltkreisen erleichtert und insbesondere ein Dünnschleifen der so gekennzeichneten Wafer ermöglicht.

Erfindungsgemäß wird diese Aufgabe durch die Maßnahmen des Patentanspruchs 1 gelöst.

Tinte ist im Gegensatz zum bislang im Stand der Technik verwendeten Lack in erheblich dünneren Schichten aufbringbar. So kann die Markierung eine Dicke von höchstens 2 µm, vorzugsweise von höchstens 1 µm aufweisen. Um die Tinte in Form der anzubringenden Markierung auf den integrierten Schaltkreis aufbringen zu können, wird vorzugsweise ein Tintenstrahldruckverfahren verwendet, so dass die verwendete Tinte dementsprechend eine zur Bedruckung mittels des Tintenstrahldruckverfahrens geeignete Zusammensetzung aufweisen sollte. Tintenstrahldruckverfahren sind seit längerem in Gebrauch und finden weite Verwendung in der Datenverarbeitung. Tintenstrahldruckverfahren zeichnen sich durch geringe Kosten, einen einfachen apparativen Aufbau und eine Berührungsfreiheit zwischen Druckkopf und zu bedruckendem Medium aus. Erfindungsgemäß können die üblichen am Markt befindlichen Tintenstrahldruckerverfahren verwendet werden, beispielsweise ein piezoelektrisches Verfahren, bei dem die Tinte aus einer Kammer mittels eines kontrahierenden oder elongierenden piezoelektrischen Elements tröpfchenweise herausgedrückt wird, oder durch das ältere Heizkammerverfahren, bei dem Tinte an der Düse so erhitzt wird, daß eine Gasblase entsteht, welche ein Tintentröpfchen aus der Düse schlagartig ausstößt.

Tintenstrahldruckverfahren weisen den weiteren Vorteil auf, in hoher Auflösung Abbildungen erzeugen zu können. Dies gibt eine weitgehende Freiheit bei der Definition der anzubringenden Markierung. Solche Markierungen können beispielsweise einen Barcode aufweisen, eine Abfolge von Zeichen, wie Ziffern oder Buchstaben oder auch ein Piktogramm einschließlich einfacher geometrischer Figuren sowie Kombinationen dieser Formen.

Das Korrelieren erfolgt erfindungsgemäß anhand von Eigenschaften des zumindest einen integrierten Halbleiters, wobei bestimmten Eigenschaften dieses integrierten Schaltkreises vorbestimmte Markierungen zugeordnet sind. Eigenschaften können beispielsweise die Leistungsfähigkeit des Schaltkreises, das heißt beispielsweise seine Geschwindigkeit, sein Stromverbrauch oder weitere Eigenschaften sein. In einer geeigneten Testapparatur könnte beispielsweise ein Testgerät die Schaltkreise testen, die Ergebnisse an eine geeignete Datenverarbeitungseinrichtung weitergeben bzw. Teil dieser Datenverarbeitungseinrichtung sein, und diese könnte nach entsprechenden Vorgaben eine Kennzeichnung für den getesteten Schaltkreis konzipieren oder aus einer Datenbank auswählen.

Das Anbringen der Markierung erfolgt durch entsprechende Ansteuerung eines Tintenstrahldruckkopfes, welcher zuvor über dem zu markierenden Schaltkreis positioniert wird.

Die Markierungen enthalten entsprechend codiert diese Informationen. So ist es in nachfolgenden Schritten möglich, die vereinzelten integrierten Schaltkreise entsprechend ihrer Markierung weiter zu verwenden beziehungsweise auszusortieren.

Die Erfindung ist weiterhin gerichtet auf ein Verfahren zum Dünnschleifen von Wafern mit folgenden Schritten:
- ennzeichnen von integrierten Schaltkreisen auf dem Wafer mittels des oben genannten erfindungsgemäßen Verfahrens;
- Anordnen des markierten Wafers mit der markierten Seite zu einem Halter hin; und
   Dünnschleifen der markierungsabgewandten Seite des Wafers.

Ziel der Erfindung ist ein Dünnschleifen des Wafers nach seiner Markierung zu ermöglichen. Das erfindungsgemäße Verfahren zum Dünnschleifen ist erst durch die Verwendung von Tinte anstelle von Lack überhaupt möglich geworden.

Das erfindungsgemäße Verfahren ermöglicht das Einspannen von markierten Wafern in herkömmliche Chucks und das Dünnschleifen der Wafer ohne eine immanente Bruchgefahr. Es ist einfach und preisgünstig zu realisieren und kann mittels üblicher Standardbaugruppen und -vorrichtungen realisiert werden.

## Patentansprüche

1. Verfahren zum Kennzeichnen von integrierten Schaltkreisen auf Wafern mit einer Markierung; mit folgenden Schritten:
- Korrelieren zumindest eines funktionsfähigen integrierten Schaltkreises mit einer an ihm anzubringenden Markierung, wobei das Korrelieren anhand von Eigenschaften des zumindest einen integrierten Schaltkreises erfolgt und bestimmten Eigenschaften vorbestimmte Markierungen zugeordnet sind; und
- Anbringen der den Schaltkreiseigenschaften zugeordneten Markierung, wobei die Markierung aus Tinte besteht.

2. Verfahren nach Anspruch 1, **dadurch gekennzeichnet, dass** die Markierung eine Dicke von höchstens 2 Mikrometern aufweist.

3. Verfahren nach Anspruch 1 oder 2, **dadurch gekennzeichnet, dass** die Markierung eine Dicke von höchstens 1 Mikrometer aufweist.

4. Verfahren nach einem der Ansprüche 1 bis 3, **dadurch gekennzeichnet, dass** die Markierung mittels eines Tintenstrahldruckverfahrens auf dem zumindest einen integrierten Schaltkreis angebracht wird.

5. Verfahren nach Anspruch 4, **dadurch gekennzeichnet, dass** das Tintenstrahldruckverfahren ein piezoelektrisches Verfahren ist.

6. Verfahren nach Anspruch 4, **dadurch gekennzeichnet, dass** das Tintenstrahldruckverfahren ein Heizkammerverfahren ist.

7. Verfahren nach einem der Ansprüche 1 bis 6, **dadurch gekennzeichnet, dass** die Markierung einen Barcode aufweist.

8. Verfahren nach einem der Ansprüche 1 bis 7, **dadurch gekennzeichnet, dass** die Markierung eine Abfolge aus zumindest einem Zeichen aufweist.

9. Verfahren nach einem der Ansprüche 1 bis 8, **dadurch gekennzeichnet, dass** die Markierung ein Piktogramm aufweist.

10. Verfahren zum Dünnschleifen von Wafern mit folgenden Schritten:
- Kennzeichnen von integrierten Schaltkreisen auf dem Wafer mittels des Verfahrens nach einem der Patentansprüche 1 bis 9;
- Anordnen des markierten Wafers mit der markierten Seite zu einem Halter hin; und
- Dünnschleifen der markierungsabgewandten Seite des Wafers.

## Claims

1. Method for identifying integrated circuits on wafers with a marking; comprising the following steps:
- correlating at least one functional integrated circuit with a marking to be attached thereto, the correlating being effected on the basis of properties of the at least one integrated circuit and predetermined markings being assigned to specific properties; and
- attaching the marking assigned to the circuit properties, the marking consisting of ink.

2. Method according to Claim 1, **characterized in that** the marking has a thickness of at most 2 micrometres.

3. Method according to Claim 1 or 2, **characterized in that** the marking has a thickness of at most 1 micrometre.

4. Method according to any of Claims 1 to 3, **characterized in that** the marking is attached on the at least one integrated circuit by means of an inkjet printing method.

5. Method according to Claim 4, **characterized in that** the inkjet printing method is a piezoelectric method.

6. Method according to Claim 4, **characterized in that** the inkjet printing method is a heating chamber method.

7. Method according to any of Claims 1 to 6, **characterized in that** the marking has a barcode.

8. Method according to any of Claims 1 to 7, **characterized in that** the marking has a sequence composed of at least one character.

9. Method according to any of Claims 1 to 8, **characterized in that** the marking has a pictogram.

10. Method for thinning wafers by grinding, comprising the following steps:
- identifying integrated circuits on the wafer by means of the method according to any of Patent Claims 1 to 9;
- arranging the marked wafer with the marked side towards a holder; and
- thinning the marking-remote side of the wafer by grinding.

## Revendications

1. Procédé de caractérisation de circuits intégrés sur des tranches par un repère, comprenant les stades suivants, dans lesquels :
- on met au moins un circuit intégré apte à fonctionner en corrélation avec un repère qui y est apposé, la corrélation s'effectuent au moyen de propriétés du au moins un circuit intégré et des repères déterminés à l'avance étant affectés à certaines propriétés ; et
- on appose le repère affecté aux propriétés du circuit, le repère étant constitué d'encre.

2. Procédé suivant la revendication 1, **caractérisé en ce que** le repère a une épaisseur de 2 microns au plus.

3. Procédé suivant la revendication 1 ou 2, **caractérisé en ce que** le repère a une épaisseur de 1 micron au plus.

4. Procédé suivant l'une des revendications 1 à 3, **caractérisé en ce qu'**on appose le repère sur le au moins un circuit intégré au moyen d'un procédé d'impression à jet d'encre.

5. Procédé suivant la revendication 4, **caractérisé en ce que** le procédé d'impression à jet d'encre est un procédé piézoélectrique.

6. Procédé suivant la revendication 4, **caractérisé en ce que** le procédé d'impression à jet d'encre est un procédé à chambre de chauffage.

7. Procédé suivant l'une des revendications 1 à 6, **caractérisé en ce que** le repère comporte un code-barres.

8. Procédé suivant l'une des revendications 1 à 7, **caractérisé en ce que** le repère comporte une succession d'au moins un signe.

9. Procédé suivant l'une des revendications 1 à 68, **caractérisé en ce que** le repère comporte un pictogramme.

10. Procédé de rodage en couches minces de tranches, comprenant les stades suivants, dans lesquels :
- on caractérise des circuits intégrés sur la tranche au moyen du procédé suivant l'une des revendications 1 à 9 ;
- on dispose la tranche sur laquelle est apposé le repère alors qu'elle a sa face sur laquelle est apposé le repère dirigée vers une fixation ; et
- on rôde en couche mince la face de la tranche éloignée de celle sur laquelle est apposé le repère.
